# FASCICULE DE BREVET EUROPEEN

(11) **EP 1 451 875 B1**
(45) Date de publication et mention de la délivrance du brevet: **25.10.2006**
(21) Numéro de dépôt: 02801106.2
(22) Date de dépôt: 09.12.2002
(51) Int. Cl.: H01L 27/146, H01L 31/18

(54) **PROCEDE DE REALISATION D'UN DISPOSITIF D'IMAGERIE**
VERFAHREN ZUR HESTELLUNG EINER ABBILDUNGSVORRICHTUNG
METHOD FOR PRODUCING AN IMAGING DEVICE

(30) Priorité: 10.12.2001 FR 0115911
(43) Date de publication de la demande: 01.09.2004
(73) Titulaire: COMMISSARIAT A L'ENERGIE ATOMIQUE, 75752 Paris Cédex 15 (FR); CENTRE NATIONAL DE LA RECHERCHE SCIENTIFIQUE (CNRS), 75794 Paris Cedex 16 (FR)
(72) Inventeur: MONGELLAZ, François DI, (FR); LINCOT, Daniel, F-92160 Antony (FR)
(74) Mandataire: Poulin, Gérard
(86) Numéro de dépôt international: PCT/FR2002/004234
(87) Numéro de publication internationale: WO 2003/050875

(56) Documents cités:
- EP-A- 0 930 657
- US-A- 3 968 360
- US-A- 5 065 006

## Description

### Domaine technique

La présente invention concerne un procédé de réalisation d'un dispositif d'imagerie.

### Etat de la technique

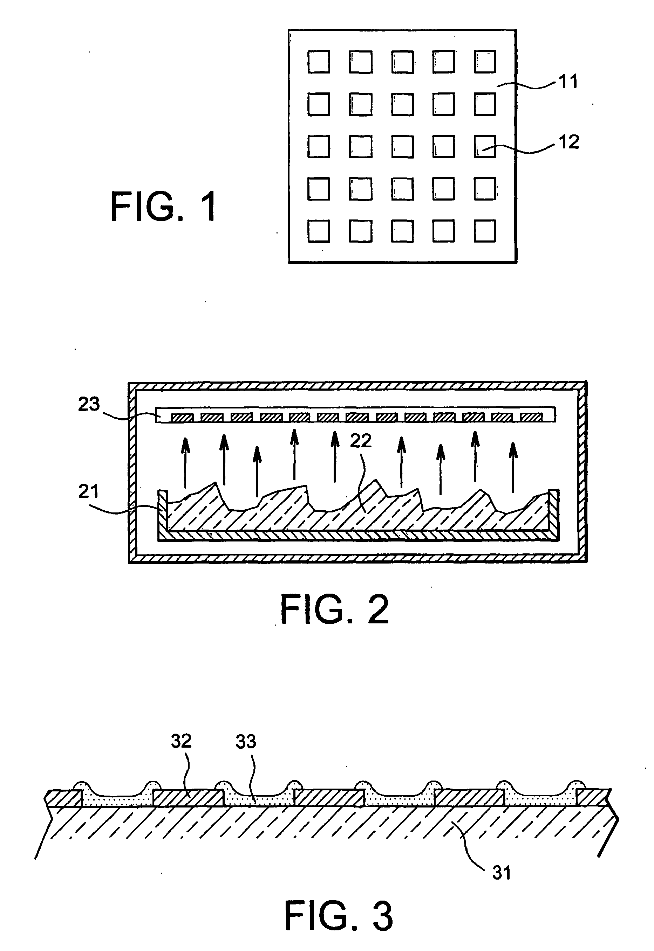

Un procédé de réalisation d'un dispositif d'imagerie de rayonnement X est décrit dans le document référencé [1] en fin de description. Comme illustré sur la figure 1, ce dispositif d'imagerie comprend une matrice de pixels réalisée en matériau semi-conducteur, pour convertir les photons X incidents en charges électriques. Ce matériau semi-conducteur est déposé sur un panneau de lecture de charges électriques à base de silicium 11, comprenant plusieurs dispositifs électroniques intégrés chacun au niveau d'un pixel de la matrice 12.

Ce procédé de réalisation consiste en un transfert par phase vapeur (méthode CSVT ou "Closed-Spaced Vapor Transport") du matériau semi-conducteur sur un substrat à base de silicium intégrant les dispositifs électroniques.

Comme illustré sur la figure 2, une source 21 comportant le matériau semi-conducteur 22, qui peut être massive ou sous forme de poudre, est chauffée à une température T1 de l'ordre de 600°C. Le matériau semi-conducteur utilisé comme source (CdTe, PbI₂, HgI₂) est proche du substrat 23 (1 à 10 mm). La température du substrat est régulée à une température T2 inférieure à T1. Elle varie de 200°C à 600°C selon la nature du semi-conducteur utilisé et la qualité de la couche exigée. Le gradient de température qui est créé permet un transport de matière entre la source 21 et le substrat 23. Les propriétés physiques des semiconducteurs utilisés associées à l'utilisation de la méthode CSVT permettent d'imposer au substrat une température (200°C à 450°C) compatible à la tenue en température des dispositifs électroniques.

Le dispositif d'imagerie de rayonnements X ainsi obtenu peut avoir des dimensions allant de quelques centimètres x quelques centimètres à plus de 40 centimètres x 40 centimètres. Il peut être utilisé, en particulier, pour l'imagerie médicale : il est apte à fonctionner en mode radiographie ou en mode radioscopie.

Dans un tel dispositif la surface du substrat, sur laquelle le dépôt de matériau semi-conducteur s'effectue, est une surface hétérogène. En effet, comme illustré sur la figure 3, la surface de ce substrat 31, qui peut être amorphe, amorphe recristallisé, polycristallin ou monocristallin, est composée d'une couche de passivation 32 (SiOₓ, ou SiN, ou SiOₓ+SiN), dans laquelle des ouvertures laissent libres les surfaces métalliques 33 (aluminium ou un autre métal) qui assurent la pixélisation de chaque matrice. Le matériau semi-conducteur doit être en contact électrique avec ces surfaces métalliques et adhérer à celles-ci.

Le dépôt du matériau semi-conducteur s'effectue donc sur une surface comportant des zones de compositions chimiques différentes. L'affinité chimique entre les matériaux composant ces zones et le matériau semi-conducteur à déposer est fonction des conditions de dépôt. L'obtention d'une bonne affinité chimique, qui est le garant d'une bonne adhérence entre le substrat de silicium et le matériau semi-conducteur, impose des conditions de dépôt : températures T1 et T2, vitesse de croissance, histoire thermique, qui influent sur les propriétés physiques du matériau semi-conducteur. Les propriétés physiques ainsi obtenues ne sont pas nécessairement compatibles avec celles recherchées pour la détection de rayonnement.

Il y a donc un problème d'adhérence entre la surface du substrat de silicium et le matériau semi-conducteur.

L'invention a pour objet de résoudre un tel problème d'adhérence. Le document US-A-5 065 006 décrit un procédé de réalisation d'un dispositif d'imagerie comprenant une matrice de pixels en matériau semi-conducteur placé sur un substrat intégrant des dispositifs électroniques et présentant des surfaces métalliques dans lequel un matériau conducteur apte à favoriser l'adhérence du matériau semi-conducteur est interposé entre le substrat et le dispositif d'imagerie.

### Exposé de l'invention

La présente invention concerne un procédé de réalisation d'un dispositif d'imagerie comprenant au moins une matrice de pixels en matériau semi-conducteur détecteur de photons déposé sur un substrat intégrant des dispositifs électroniques et présentant des surfaces métalliques, caractérisé en ce que, préalablement au dépôt du matériau semi-conducteur sur ledit substrat, un matériau conducteur apte à favoriser l'adhérence du matériau semi-conducteur est déposé sur les surfaces métalliques de ce substrat.

Le substrat peut être en un matériau choisi parmi Si, GaAs, InP et leurs composés respectifs.

Le matériau semi-conducteur peut être l'un des matériaux suivants : CdTe, Se, PbI₂, PbO, HgI₂, GaAs, TlBr, BiI₃ ou TlPbI₃.

Le matériau pour favoriser l'adhérence peut être choisi parmi Zn, Ti, Pt et Ni.

La surface du substrat est une surface hétérogène, qui est composée d'une couche de passivation, dans laquelle des ouvertures laissent libres les surfaces métalliques. Elle peut être réalisée dans l'un des matériaux suivants : SiOₓ, ou SiN, ou SiOₓ+SiN. Les surfaces métalliques sont par exemple en aluminium, en or ou en cuivre.

Avantageusement les zones de matériau apte à favoriser l'adhérence déposée sont jointives. Ce matériau a une épaisseur comprise entre quelques Angströms et quelques micromètres.

Dans un premier mode de réalisation le matériau pour favoriser l'adhérence est déposé par bain chimique. Le dépôt par bain chimique peut être réalisé en mettant la surface métallique de ce substrat au contact d'une solution réactive contenant l'élément à déposer sous forme dissoute. Dans une première catégorie de solutions l'élément à déposer réagit avec le métal, en le dissolvant par oxydation et en se déposant à sa place. Cet élément à déposer est compris parmi les matériaux suivants : Zin, Cd, Sn, Se, Cu, Te, Bi et In. Dans une deuxième catégorie de solutions, l'élément à déposer est introduit dans la solution avec un élément capable de le déposer sur le substrat. Les éléments à déposer sont compris parmi les matériaux suivants : Ni, Sn, Cu, Au.

Dans un deuxième mode de réalisation le matériau apte à favoriser l'adhérence est déposé par électro-dépôt. Ce matériau est compris parmi les matériaux suivants : un métal : Zn, Cu, Ni, Pb, Te, Se, Cd, Sn, Au, un alliage métallique ou un composé non métallique, comme par exemple oxyde ou hydroxide, un chalcogénure métallique (MS, MSe, MTe où M est un métal).

Le substrat jouant le rôle de première électrode est immergé dans une solution chimique adaptée contenant les éléments à déposer sous forme d'ions, une fonction spécifique du substrat permettant de relier toutes les surfaces métalliques ensemble et de les porter toutes au même potentiel. Une seconde électrode est immergée dans la solution, elle-même portée à un potentiel fonction de la réaction d'électrolyse. Le passage d'un courant entre les deux électrodes permet d'obtenir des réactions d'oxydoréduction, et de déposer le composé apte à favoriser l'adhérence à la surface d'une des électrodes

Dans un troisième mode de réalisation le matériau est déposé en phase vapeur ou gazeuse ou par pulvérisation. Le substrat est introduit dans un bâti afin d'être recouvert d'une couche de matériau apte à favoriser l'adhérence, cette couche étant déposée de manière non sélective et recouvrant la totalité de la surface du substrat. Ce matériau est alors gravé de manière sélective de façon à ne laisser le matériau présent que sur les surfaces métalliques. Le matériau peut ainsi être gravé par des opérations de photolithographie ou d'ablation laser.

Le procédé de l'invention utilise ainsi un matériau qui assure l'adhérence entre les surfaces métalliques du substrat et le matériau semi-conducteur. Il permet alors un dépôt de la couche de semi-conducteur sur le substrat.

Dans un exemple de réalisation, on utilise le procédé de l'invention pour obtenir un dispositif d'imagerie de rayonnements X qui comprend au moins une matrice de pixels permettant de convertir des photons X incidents en charges électriques, notamment dans la fabrication de panneaux de lecture pour système d'imagerie X dans le domaine médical.

### Brève description des figures

Les figures 1 et 2 illustrent le fonctionnement d'un procédé de l'art connu,
La figure 3 illustre la coupe de la surface d'un panneau de lecture avant le dépôt de la couche de matériau semi-conducteur,
La figure 4 illustre la coupe d'un ensemble panneau de lecture + zones d'adhérence non jointive + couche de semi-conducteur obtenu avec le procédé de l'invention,
La figure 5 illustre la coupe d'un ensemble panneau de lecture + zones d'adhérence jointive + couches de semi-conducteur obtenu avec le procédé de l'invention,
La figure 6 illustre le fonctionnement de la méthode électrolytique qui peut être utilisée dans le procédé de l'invention.

### Exposé détaillé de modes de réalisation

Conformément au document référencé [1], dans le procédé de l'invention, une matrice de pixels en matériau semi-conducteur détecteur de photons est réalisée par le dépôt d'une couche de ce matériau sur un substrat intégrant des dispositifs électroniques et présentant des surfaces métalliques.

Pour résoudre le problème d'adhérence défini précédemment, le procédé de l'invention consiste à déposer, préalablement au dépôt du matériau semi-conducteur sur le substrat, un matériau apte à favoriser l'adhérence du matériau semi-conducteur ultérieurement déposé sur les surfaces métalliques du substrat. Ce matériau a pour objet d'assurer l'adhérence et la continuité électrique entre les surfaces métalliques du substrat et la couche de semi-conducteur et par là, entre la couche de semi-conducteur et le substrat.

Le substrat peut être en un matériau choisi parmi Si, GaAs, InP et leurs composés respectifs.

La couche de semi-conducteur peut être déposée par la méthode CSVT ou la méthode CSS ("Close Space Sublimation") mais aussi par des méthodes de transport par phase vapeur avec ou sans agent chimique, de sérigraphie, ou d'épitaxie en phase liquide, dans la mesure où les impératifs de températures définis précédemment sont respectés.

Le matériau semi-conducteur utilisé peut être choisi parmi les matériaux suivants : CdTe, PbI₂, PbO, HgI₂, GaAs, Se, TlBr, BiI₃, TlPbI₃.

Le matériau apte à favoriser l'adhérence du matériau semi-conducteur sur le substrat sera choisi en fonction du couple matériau du circuit de lecture/matériau détecteur de photons pour ses caractéristiques cristalline, électrique. Par exemple, il pourra être choisi parmi le Zn, Ti, Pt et Ni.

Lorsque la réalisation de la couche de matériau semi-conducteur est envisagée par épitaxie, alors le matériau apte à favoriser l'adhérence peut être un homo-germe, c'est-à-dire qu'il est composé des mêmes composés chimiques que la couche de semi-conducteur à réaliser. Le matériau faisant office d'homo-germe pour la croissance d'une couche de CdTe est donc CdTe, pour une couche de PbI₂ est PbI₂, pour une couche de HgI₂ est HgI₂, et pour une couche de PbO est PbO (il en de même pour GaAs, Se, TlBr, BiI₃, TlPbI₃).

Pour le choix du matériau apte à favoriser l'adhérence, un homme de métier pourrait aussi être amené à choisir un matériau de structure cristalline différente de celle de la couche de semi-conducteur. Un tel choix permet, en effet, de mettre en évidence la présence du matériau. De plus, on peut s'attendre à ce que ce dernier, de par sa structure cristalline différente, fasse office de barrière de diffusion entre les éléments chimiques constituant les surfaces métalliques et la couche de matériau semi-conducteur, les propriétés électriques de cette dernière étant très sensibles à la présence de dopants, même en faibles quantités (de l'ordre de quelques ppb à quelques ppm).

Mais l'utilisation d'un matériau germe de mêmes structures cristallines, ou "homo-germe", selon l'invention élargit le domaine des conditions de croissance compatibles avec l'adhérence, car il y a forcément affinité chimique. Le choix des conditions de croissance conduit nécessairement à l'élaboration d'une couche de semi-conducteur possédant les propriétés physiques requises.

Ce matériau apte à favoriser l'adhérence est déposé sur les surfaces métalliques et a une épaisseur comprise entre quelques d'Angstrôms et quelques micromètres.

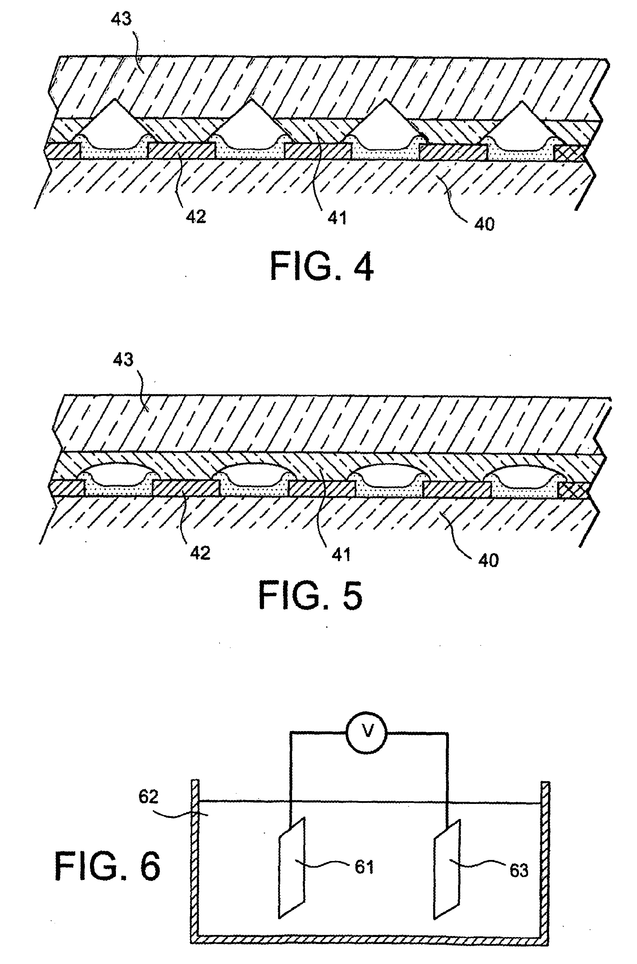

Comme illustré sur la figure 4, ce matériau 41 doit être présent à la surface du substrat 40, être adhérent aux surfaces métalliques 42 dudit substrat, assurer une continuité électrique avec ces surfaces métalliques, et permettre l'adhérence du matériau semi-conducteur 43. Sur cette figure 4, les zones 41 formées par ce matériau déposé sur les surfaces métalliques sont non jointives.

Mais on peut avoir intérêt, comme illustré sur la figure 5, à ce que ces zones soient jointives pour des raisons de nucléation de la couche de semi-conducteur 43 qui est déposée au-dessus.

Le matériau apte à favoriser l'adhérence peut être déposé en utilisant différentes méthodes, notamment le bain chimique, l'électro-dépôt, comme décrit dans le document référencé [2], la phase vapeur ou gazeuse ou la pulvérisation.

Ce matériau peut ainsi être déposé par bain chimique. Ce dépôt par bain chimique peut être réalisé en mettant la surface métallique du substrat, par exemple en aluminium, préalablement ou non décapée pour diminuer l'épaisseur de la couche d'oxyde, au contact d'une solution réactive contenant les éléments à déposer sous forme dissoute.

Dans une première catégorie de solutions, l'élément à déposer réagit avec le métal, par exemple l'aluminium, le dissolvant par oxydation et en se déposant à sa place. Cette méthode de dépôt, appelée par déplacement, est préférablement utilisée pour les ions métalliques (ou non) dont le potentiel de réduction est plus élevé que le potentiel d'oxydation de l'aluminium ; ces éléments peuvent être : Zin, Cd, Pb, Sn, Se, Cu, Te, Bi, In, l'élément préféré étant le zinc.

Dans une deuxième catégorie de solutions l'élément à déposer est introduit dans la solution avec un élément capable de le déposer sélectivement sur le substrat, par exemple en aluminium, préalablement recouvert ou non d'une première couche, réalisée par la méthode précédente. Dans ce cas, il n'y a pas attaque de l'aluminium et l'intégrité de la couche d'aluminium peut être préservée. Les éléments à déposer peuvent être le Ni, Sn, Cu, Au... Les éléments préférés sont Ni et Sn.

Les couches déposées chimiquement peuvent comporter plusieurs éléments métalliques, ou non métalliques, conduisant à ces alliages ou des couches (oxydes, hydroydes, chalcogénures...).

Les solutions permettant ces réactions peuvent être aqueuses ou non aqueuses.

Ce matériau peut également être déposé, par électro-dépôt comme illustré sur la figure 6.

Ce matériau peut être un métal : Zn, Cu, Ni, Pb, Te, Se, Cd, Sn, Au, un alliage métallique, ou un composé non métallique, comme par exemple un oxyde ou hydroxide, un chalcogénure métallique (MS, MSe, MTe où M est un métal). Les matériaux préférés sont : CdTe, CdSe, ZnTe, ZnSe, CdS, ZnS, PbSe, SnOx; SnSx, SnTex, SnSex, CuX, InX. Les alliages ternaires sont aussi possibles. Ce dépôt peut être effectué en milieu aqueux ou en milieu non aqueux, de préférence en milieu aqueux. Ce dépôt peut être effectué suivant les modes galvanostatique, potentiostatique ou toute combinaison de ces méthodes (voltamétrie, dépôt pulsé).

Comme illustré sur la figure 6, le substrat 61 (première électrode) est immergé dans une solution chimique adaptée contenant les éléments à déposer sous forme d'ions 62 (électrolyte). Une fonction spécifique de ce substrat 61 permet de relier toutes les surfaces métalliques ensemble (court-circuit) et permet de les porter toutes au même potentiel. Une seconde électrode 63 est immergée dans la solution, elle-même portée à un potentiel fonction de la réaction d'électrolyse. Le passage d'un courant entre les deux électrodes permet d'obtenir des réactions d'oxydoréduction, et de déposer le composé recherché (CdTe, HgI₂, PbI₂, BpO, Ga, As, Se, TlBr, BiI₃, TlPbI₃) à la surface d'une électrode. Etant donné que seules les zones libres des surfaces métalliques permettent le passage du courant (donc les échanges d'électrons), seules les surfaces métalliques polarisées sont recouvertes du matériau déposé par électrolyse. Dans ce cas, les zones déposées sont non jointives. Dans les autres méthodes (bain, pulvérisation), les zones déposées peuvent être jointives. En effet, le substrat est introduit dans un bâti afin d'être recouvert d'une couche de matériau apte à favoriser l'adhérence. Cette couche est déposée de manière non sélective et recouvre la totalité de la surface du substrat. Dans certains cas, le matériau pourra alors être gravé de manière sélective de façon à ne laisser présent le matériau que sur les surfaces métalliques, par exemple par des opérations de photolithographie ou par ablation laser ou par toute méthode de gravure.

### REFERENCES

[1] FR-A-2 791 469
[2] "Electrochemistry of semiconductors and electronics. Processes and Devices" de John Mc Hardy et Franck Ludwig (Noyes Publications, 1992)

## Revendications

1. Procédé de réalisation d'un dispositif d'imagerie comprenant au moins une matrice de pixels en matériau semi-conducteur détecteur de photons déposé sur un substrat (40) intégrant des dispositifs électroniques et présentant des surfaces métalliques (42), **caractérisé en ce que**, préalablement au dépôt du matériau semi-conducteur (43) sur ledit substrat, un matériau conducteur apte à favoriser l'adhérence du matériau semi-conducteur (43) sur les surfaces métalliques est déposé sur lesdites surfaces métalliques (42) de ce substrat (40).

2. Procédé selon la revendication 1, dans lequel le substrat est en un matériau choisi parmi Si, GaAs, InP et leurs composés respectifs.

3. Procédé selon la revendication 1, dans lequel le matériau semi-conducteur (43) est l'un des matériaux suivants : CdTe, Se, PbI₂, PbO, HgI₂, GaAs, TlBr, BiI₃ ou TlPbI₃.

4. Procédé selon la revendication 1, dans lequel le matériau pour favoriser l'adhérence est choisi parmi Zn, Ti, Pt et Ni.

5. Procédé selon la revendication 1, dans lequel la surface du substrat est une surface hétérogène, qui est composée d'une couche de passivation, dans laquelle des ouvertures laissent libres les surfaces métalliques.

6. Procédé selon la revendication 5, dans lequel la couche de passivation est réalisée dans l'un des matériaux suivants : SiOₓ, ou SiN, ou SiOₓ+SiN.

7. Procédé selon la revendication 5, dans lequel les surfaces métalliques (42) sont en aluminium, en or ou en cuivre.

8. Procédé selon la revendication 1, dans lequel les zones formées par le matériau pour favoriser l'adhérence déposé (41) sont jointives.

9. Procédé selon la revendication 1, dans lequel le matériau pour favoriser l'adhérence a une épaisseur comprise entre quelques Angströms et quelques micromètres.

10. Procédé selon la revendication 1, dans lequel le matériau pour favoriser l'adhérence est déposé par bain chimique.

11. Procédé selon la revendication 10, dans lequel on met la surface métallique de ce substrat au contact d'une solution réactive contenant l'élément à déposer sous forme dissoute.

12. Procédé selon la revendication 11, dans lequel l'élément à déposer réagit avec le métal, le dissolvant par oxydation et en se déposant à sa place.

13. Procédé selon la revendication 12, dans lequel l'élément à déposer est compris parmi les matériaux suivants : Zin, Cd, Pb, Sn, Se, Cu, Te, Bi, et In.

14. Procédé selon la revendication 11, dans lequel l'élément à déposer est introduit dans la solution avec un élément capable de le déposer sélectivement sur le substrat.

15. Procédé selon la revendication 14, dans lequel les éléments à déposer sont compris parmi les matériaux suivants : Ni, Sn, Cu, Au.

16. Procédé selon la revendication 1, dans lequel le matériau pour favoriser l'adhérence est déposé par électro-dépôt.

17. Procédé selon la revendication 16, dans lequel ce matériau est compris parmi les matériaux suivants : un métal : Zn, Cu, Ni, Pb, Te, Se, Cd, Sn, Au, un alliage métallique, ou composé non métallique, un chalcogénure métallique.

18. Procédé selon la revendication 17, dans lequel le composé non métallique est un oxyde ou un hydroxide.

19. Procédé selon la revendication 16, dans lequel le substrat, jouant le rôle de première électrode, est immergé dans une solution chimique adaptée contenant les éléments à déposer sous forme d'ions, une fonction spécifique du substrat permettant de relier toutes les surfaces métalliques ensemble et de les porter toutes au même potentiel, dans lequel une seconde électrode est immergée dans la solution, elle-même portée à un potentiel fonction de la réaction d'électrolyse, et dans lequel le passage d'un courant entre les deux électrodes permet d'obtenir des réactions d'oyxdo-réduction, et de déposer le matériau favorisant l'adhérence à la surface de l'une des électrodes.

20. Procédé selon la revendication 1, dans lequel le matériau pour favoriser l'adhérence est déposé en phase vapeur ou gazeuse ou par pulvérisation.

21. Procédé selon la revendication 1, dans lequel le substrat est introduit dans un bâti afin d'être recouvert d'une couche de matériau pour favoriser l'adhérence, cette couche étant déposée de manière non sélective et recouvrant la totalité de la surface du substrat, et dans lequel ce matériau est alors gravé de manière sélective de façon à ne laisser ce matériau présent que sur les surfaces métalliques.

22. Procédé selon la revendication 1, dans lequel le matériau apte à favoriser l'adhérence est identique au matériau semi-conducteur et constitue un homo-germe et dans lequel la couche de matériau semi-conducteur est obtenue par croissance cristalline à partir de cet homo-germe.

23. Procédé, selon la revendication 1, de réalisation d'un dispositif d'imagerie de rayonnements X, comprenant au moins une matrice de pixels permettant de convertir des photons X incidents en charges électriques.

## Claims

1. Method for making an imagery device comprising at least one matrix of pixels made of a photon detecting semiconducting material, deposited on a substrate (40) in which electronic devices are integrated and with metallic surfaces (42), **characterised in that** a conducting material capable of improving bond of the semiconducting material (43) is deposited on the said metallic surfaces (42) of this substrate (40) before the semiconducting material (43) is deposited on the said substrate.

2. Method according to claim 1, in which the substrate is made from a material chosen from among Si, GaAs, InP and compounds of these materials.

3. Method according to claim 1, in which the semiconducting material (43) is chosen from among CdTe, Se, PbI₂, PbO, HgI₂, GaAs, TlBr, BiI₃ or TlPbI₃.

4. Method according to claim 1, in which the material used to improve bond is chosen from among Zn, Ti, Pt and Ni.

5. Method according to claim 1, in which the surface of the substrate is a heterogeneous surface composed of a passivation layer, in which there are openings leaving the metallic surfaces free.

6. Method according to claim 5, in which the passivation layer is made from a material chosen from among SiOₓ, or SiN, or SiOₓ, + SiN.

7. Method according to claim 5, in which the metallic surfaces (42) are made of aluminium, gold or copper.

8. Method according to claim 1, in which the areas formed by the material deposited to improve bond (41) are contiguous.

9. Method according to claim 1, in which the thickness of the material to improve bond is between a few Angstroms and a few micrometers.

10. Method according to claim 1, in which the material to improve bond is deposited by chemical bath.

11. Method according to claim 10, in which the metallic surface of this substrate is put into contact with a reactive solution containing the element to be deposited in dissolved form.

12. Method according to claim 11, in which the element to be deposited reacts with the metal, dissolving it by oxidation, and being deposited to replace it.

13. Method according to claim 12, in which the element to be deposited is chosen from among Zin, Cd, Sn, Se, Cu, Te, Bi and In.

14. Method according to claim 11, in which the element to be deposited is added in the solution with an element capable of selectively depositing it on the substrate.

15. Method according to claim 14, in which the elements to be deposited are chosen from among Ni, Sn, Cu, Au.

16. Method according to claim 1, in which the material to improve bond is deposited by electrodeposition.

17. Method according to claim 16, in which this material is a metal, chosen from among Zn, Cu, Ni, Pb, Te, Se, Cd, Sn, Au, or a metal alloy or a non-metallic compound, a metallic chalcogenide.

18. Method according to claim 17, in which the non-metallic compound is an oxide or hydroxide.

19. Method according to claim 16, in which the substrate acting as the first electrode is immersed in an adapted chemical solution containing elements to be deposited in ion form, a specific function of the substrate connecting all metallic surfaces to each other and bringing them all to the same potential, in which a second electrode is immersed in the solution, itself at a potential that depends on the electrolysis reaction, and in which passing a current between the two electrodes results in oxidation - reduction reactions, so that the compound that can improve bond is deposited on the surface of one of the electrodes.

20. Method according to claim 1, in which the material to improve bond is deposited in a vapour or gaseous phase or by atomisation.

21. Method according to claim 1, in which the substrate is placed in a frame so that it can be covered by a layer of material that can improve bond, this layer being arranged non-selectively and covering the entire surface of the substrate, and in which this material is then selectively etched so as to leave material only on the metallic surfaces.

22. Method according to claim 1, in which the material for improving bond is identical to the semiconducting material and forms a homogerm in which the layer of semiconducting material is obtained by crystalline growth starting from this homogerm.

23. Method according to claim 1, for making an X-ray imagery device comprising at least one matrix of pixels to convert incident X photons into electrical charges.

## Patentansprüche

1. Verfahren zur Herstellung einer Bilderzeugungs-Vorrichtung, die umfasst mindestens eine Pixel(Bildelement)-Matrix aus einem Fotonendetektor-Halbleiter-Material, das auf einem Substrat (40) abgeschieden worden ist, das elektronische Einrichtungen integriert und Metalloberflächen (42) aufweist, **dadurch gekennzeichnet, dass** vor der Abscheidung des Halbleiter-Materials (43) auf dem genannten Substrat ein elektrisch leitendes Material, das die Haftung des Halbleiter-Materials (43) an den Metalloberflächen fördern kann, auf den genannten Metalloberflächen (42) dieses Substrats (40) abgeschieden wird.

2. Verfahren nach Anspruch 1, bei dem das Substrat aus einem Material, ausgewählt aus der Gruppe Si, GaAs, InP und ihren jeweiligen Verbindungen, besteht.

3. Verfahren nach Anspruch 1, bei dem das Halbleiter-Material (43) eines der folgenden Materialien ist: CdTe, Se, Pbl₂, PbO, Hgl₂, GaAs, TlBr, Bil₃ oder TlPbl₃.

4. Verfahren nach Anspruch 1, bei dem das Material, das die Haftung fördert, ausgewählt ist aus der Gruppe Zn, Ti, Pt und Ni.

5. Verfahren nach Anspruch 1, bei dem die Oberfläche des Substrats eine heterogene Oberfläche ist, die aus einer Passivierungsschicht besteht, in der Öffnungen vorgesehen sind, welche die Metalloberflächen frei lassen.

6. Verfahren nach Anspruch 5, bei dem die Passivierungsschicht aus einem der folgenden Materialien hergestellt ist: SiOₓ oder SiN oder SiOₓ+SiN.

7. Verfahren nach Anspruch 5, bei dem die Metalloberflächen (42) aus Aluminium, aus Gold oder aus Kupfer bestehen.

8. Verfahren nach Anspruch 1, bei dem die Zonen (41), die aus dem Material hergestellt sind, das die Haftung fördert, nebeneinander liegend angeordnet sind.

9. Verfahren nach Anspruch 1, bei dem das Material zur Förderung der Haftung eine Dicke aufweist, die zwischen einigen Å und einigen µm liegt.

10. Verfahren nach Anspruch 1, bei dem das Material zur Förderung der Haftung mittels eines chemischen Bades abgeschieden wird.

11. Verfahren nach Anspruch 10, bei dem man die Metalloberfläche des Substrats mit einer reaktionsfähigen Lösung in Kontakt bringt, die das abzuscheidende Element in gelöster Form enthält.

12. Verfahren nach Anspruch 11, bei dem das abzuscheidende Element mit dem Metall reagiert, wobei es dieses durch Oxidation auflöst und an seiner Stelle abgeschieden wird.

13. Verfahren nach Anspruch 12, bei dem das abzuscheidende Element ausgewählt wird aus den folgenden Materialien: Zn, Cd, Pb, Sn, Se, Cu, Te, Bi und In.

14. Verfahren nach Anspruch 11, bei dem das abzuscheidende Element in die Lösung eingeführt wird mit einem Element, das es selektiv auf dem Substrat abscheiden kann.

15. Verfahren nach Anspruch 14, bei dem die abzuscheidenden Elemente ausgewählt werden aus den folgenden Materialien: Ni, Sn, Cu, Au.

16. Verfahren nach Anspruch 1, bei dem das Material zur Förderung der Haftung durch elektrolytische Abscheidung abgeschieden wird.

17. Verfahren nach Anspruch 16, bei dem das Material ausgewählt wird aus den folgenden Materialien: einem Metall aus der Gruppe Zn, Cu, Ni, Pb, Te, Se, Cd, Sn, Au, einer Metall-Legierung oder einer nicht-metallischen Verbindung oder einem Metallchalcogenid.

18. Verfahren nach Anspruch 17, bei dem die nicht-metallische Verbindung ein Oxid oder Hydroxid ist.

19. Verfahren nach Anspruch 16, bei dem das Substrat, das die Rolle der ersten Elektrode spielt, in eine geeignete chemische Lösung eingetaucht wird, welche die abzuscheidenden Elemente in Form von Ionen enthält, wobei eine spezifische Funktion des Substrats es ermöglicht alle Metalloberflächen miteinander zu verbinden und sie alle auf das gleiche Potential zu bringen, in dem eine zweite Elektrode in die Lösung eingetaucht wird, die selbst auf ein Potential gebracht worden ist zur Durchführung der Elektrolysereaktion, und bei dem das Fließen eines Stromes zwischen den beiden Elektroden das Auftreten von Oxidations-Reduktions-Reaktionen und die Abscheidung des Metalls, das die Haftung an der Oberfläche einer der Elektroden fördert, erlaubt.

20. Verfahren nach Anspruch 1, bei dem das Material, das die Haftung fördert, in der Dampfphase oder in der Gasphase oder durch Sputtern abgeschieden wird.

21. Verfahren nach Anspruch 1, bei dem das Substrat in eine Einrichtung eingeführt wird, um von einer Schicht aus dem Material, welche die Haftung fördert, bedeckt zu werden, wobei diese Schicht auf nicht selektive Weise derart abgeschieden wird, dass sie die Gesamtheit der Oberfläche des Substrats bedeckt, und in dem dieses Material dann auf selektive Weise geätzt wird, sodass dieses Material nur auf den Metalloberflächen verbleibt.

22. Verfahren nach Anspruch 1, bei dem das Material das geeignet ist, die Haftung zu fördern, identisch ist mit dem Halbleitermaterial und eine homogene Keimschicht darstellt und bei dem die Schicht aus dem Halbleitermaterial durch Aufwachsenlassen von Kristallen auf diese homogene Keimschicht erhalten wird.

23. Verfahren nach Anspruch 1 zur Herstellung einer Röntgenstrahlungs-Bilderzeugungs-Vorrichtung, die mindestens eine Pixel (Bildpunkt)-Matrix umfasst, welche die Umwandlung von auftreffenden Röntgen-Photonen in elektrische Ladungen erlaubt.
